# EUROPÄISCHE PATENTANMELDUNG

(11) **EP 2 200 079 A1**
(43) Veröffentlichungstag der Anmeldung: **23.06.2010**
(21) Anmeldenummer: 09014435.3
(22) Anmeldetag: 19.11.2009
(51) Int. Cl.: H01L 23/34, H01L 23/473

(54) **Verfahren und Einrichtung zum Betreiben eines Leistungshalbleiterbauelements**

(30) Priorität: 19.12.2008 DE 102008064080
(71) Anmelder: Converteam GmbH, 12277 Berlin (DE)
(72) Erfinder: Zingel, Reinhard, 12207 Berlin (DE)
(74) Vertreter: Schäfer, Wolfgang

(57) **Zusammenfassung**

Es wird eine Einrichtung (10) zum Betreiben eines Leistungshalbleiterbauelements, insbesondere eines IGBT (11) beschrieben. Dem IGBT (11) ist ein Kühlsystem (13) zugeordnet, das ein Kühlmedium (18) enthält, mit dem von dem IGBT (11) erzeugte Wärme von demselben abführbar ist. Die durch das Kühlsystem (13) geförderte Menge an Kühlmedium (18) ist einstellbar. Es sind Mittel vorgesehen, die dazu ausgebildet sind, die durch das Kühlsystem (13) geförderte Menge an Kühlmedium (18) derart zu steuern und/oder zu regeln, dass gerade so viel Wärme von dem IGBT (11) abgeführt wird, dass die Temperatur des IGBT (11) im wesentlichen konstant bleibt.

## Beschreibung

Die Erfindung betrifft ein Verfahren und eine Einrichtung zum Betreiben eines Leistungshalbleiterbauelements nach dem Oberbegriff der Ansprüche 1 und 8.

In leistungselektronischen Einrichtungen, beispielsweise in elektrischen Stromrichtern, sind häufig Leistungshalbleiterbauelemente jeglicher Art enthalten. Aufgrund der zu schaltenden Ströme erwärmen sich diese Leistungshalbleiterbauelemente in Abhängigkeit von der jeweiligen Strombelastung. Zur Vermeidung von Überhitzungen der Leistungshalbleiterbauelemente sind häufig Kühlsysteme vorgesehen, mit denen die durch die Strombelastung entstehende Wärme von den Leistungshalbleiterbauelementen abgeführt wird.

Bekannt sind beispielsweise Kühlsysteme, die zwei Kreisläufe aufweisen. In dem einen Kreislauf ist dabei ein steuerbares Ventil enthalten, mit dessen Hilfe die Temperatur des Kühlmediums in dem anderen Kreislauf auf einen erwünschten konstanten Wert gesteuert und/oder geregelt wird.

Mit den bekannten Kühlsystemen kann im Mittel eine ausreichende Kühlung der Leistungshalbleiterbauelemente erreicht werden. Starke Änderungen des Stroms über die Leistungshalbleiterbauelemente haben jedoch starke dynamische Änderungen der Temperatur derselben zur Folge. Derartige starke dynamische Temperaturschwankungen an den Leistungshalbleiterbauelementen können aber von den bekannten Kühlsystemen nicht vermieden werden.

Bekannter Weise ist jedoch die Lebensdauer vieler Leistungshalbleiterbauelemente dadurch begrenzt, dass nur eine maximale Anzahl von Temperaturzyklen durchlaufen werden kann, dass also eine große Anzahl von starken Temperaturschwankungen zu einem Defekt des jeweiligen Leistungshalbleiterbauelements führt. Die bekannten Kühlsysteme können somit einen Defekt von Leistungshalbleiterbauelementen nicht verhindern.

Aufgabe der Erfindung ist es, ein Verfahren und eine Einrichtung zum Betreiben eines Leistungshalbleiterbauelements zu schaffen, die die Möglichkeit eines Defekts des Leistungshalbleiterbauelements zumindest verringern oder möglichst verhindern.

Die Erfindung löst diese Aufgabe durch ein Verfahren nach dem Anspruch 1 und durch eine Einrichtung nach dem Anspruch 8.

Die Erfindung sieht ein Kühlsystem mit einem Kühlmedium vor, mit dem von dem Leistungshalbleiterbauelement erzeugte Wärme von demselben abführbar ist. Die durch das Kühlsystem geförderte Menge an Kühlmedium ist dabei einstellbar. Erfindungsgemäß wird die durch das Kühlsystem geförderte Menge an Kühlmedium derart gesteuert, dass gerade so viel Wärme von dem Leistungshalbleiterbauelement abgeführt wird, dass die Temperatur des Leistungshalbleiterbauelements im wesentlichen konstant bleibt.

Während also beim Stand der Technik nur die Temperatur des Kühlmediums in einem der beiden Kreisläufe des Kühlsystems im wesentlichen konstant gehalten wird, sieht die Erfindung im Unterschied dazu vor, dass die Temperatur des Leistungshalbleiterbauelements konstant gehalten wird. Damit werden Temperaturschwankungen des Leistungshalbleiterbauelements vermieden. Es treten somit keine Temperaturzyklen bei dem Leistungshalbleiterbauelement auf, so dass insoweit kein Defekt entstehen kann.

Die Konstanthaltung der Temperatur des Leistungshalbleiterelements wird dabei dadurch erreicht, dass immer so viel Kühlmedium durch das Kühlsystem gefördert wird, dass gerade so viel Wärme von dem Leistungshalbleiterbauelement abgezogen wird, dass die Temperatur desselben etwa konstant bleibt. Die Erfindung hat also erkannt, dass durch eine entsprechende dynamische Steuerung und/oder Regelung der geförderten Menge an Kühlmedium die Temperatur des Leistungshalbleiterbauelements konstant gehalten werden kann.

Bei vorteilhaften Ausgestaltungen der Erfindung wird die durch das Kühlsystem geförderte Menge an Kühlmedium derart gesteuert und/oder geregelt, dass eine voraussichtliche zukünftige Temperaturänderung des Leistungshalbleiterbauelements kompensiert wird, insbesondere wird die durch das Kühlsystem geförderte Menge an Kühlmedium erhöht, wenn sich die Temperatur des Leistungshalbleiterbauelements zukünftig voraussichtlich erhöht, und es wird die durch das Kühlsystem geförderte Menge an Kühlmedium vermindert, wenn sich die Temperatur des Leistungshalbleiterbauelements zukünftig voraussichtlich vermindert.

Besonders vorteilhaft ist es, wenn eine voraussichtliche zukünftige Temperaturänderung oder eine zukünftige voraussichtliche Temperatur des Leistungshalbleiterbauelements in Abhängigkeit von einem voraussichtlichen zukünftigen Stromverlauf über das Leitungshalbleiterbauelement ermittelt wird. Es kann somit aus dem voraussichtlichen Stromverlauf im voraus ermittelt werden, welche voraussichtlichen Temperaturänderungen an dem Leistungshalbleiterbauelement auftreten werden. In Abhängigkeit von diesen voraussichtlichen Temperaturänderungen kann dann die durch das Kühlsystem geförderte Menge an Kühlmedium derart eingestellt werden, dass die Temperaturänderungen gerade nicht auftreten, also die Temperatur des Leistungshalbleiterbauelements im wesentlichen konstant bleibt.

Bei einer besonders vorteilhaften Ausgestaltung der Erfindung wird das Kühlsystem und/oder das Leistungshalbleiterbauelement in der Form eines Modells rechnerisch nachgebildet. Damit ist es möglich, die erfindungsgemäße Konstanthaltung der Temperatur des Leistungshalbleiterbauelements auf besonders einfache Weise zu erreichen.

Besonders vorteilhaft ist es, wenn eine voraussichtliche zukünftige Temperaturänderung oder eine zukünftige voraussichtliche Temperatur des Leistungshalbleiterbauelements mit Hilfe des Modells ermittelt wird. Zusätzlich kann es zweckmäßig sein, wenn weitere Betriebsgrößen des Kühlsystems und/oder des Leistungshalbleiterbauelements von dem Modell verarbeitet werden.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.

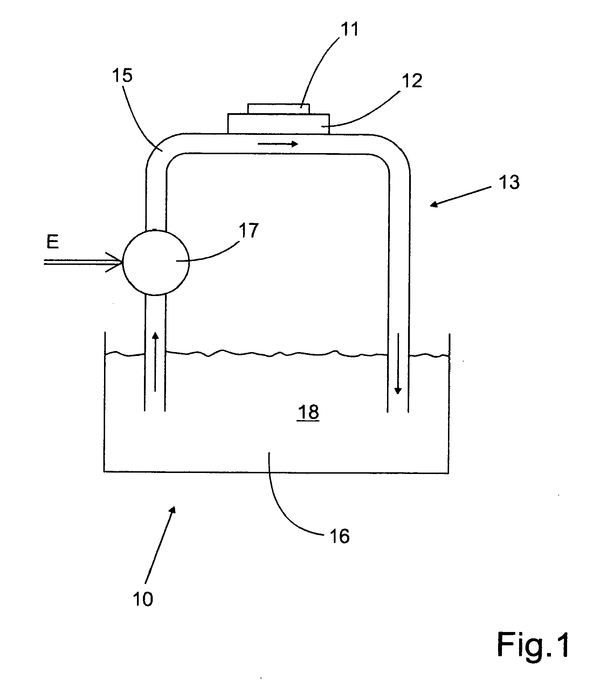

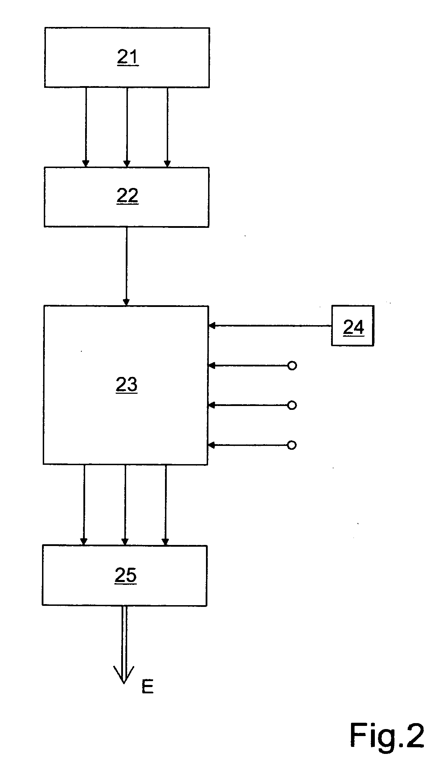

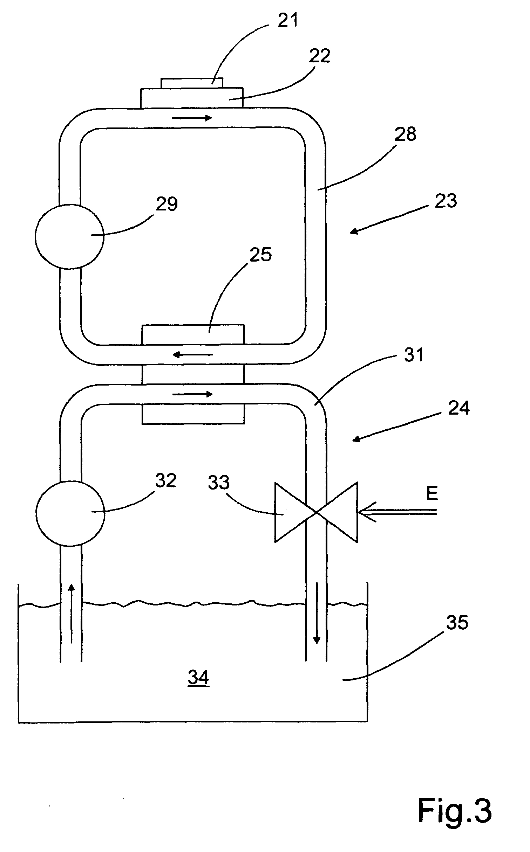

Figur 1 zeigt eine schematische Prinzipdarstellung eines ersten Ausführungsbeispiels einer erfindungsgemäßen Einrichtung zum Betreiben eines Leistüngshalbleiterbauelements, Figur 2 zeigt ein schematisches Ablaufdiagramm eines erfindungsgemäßen Verfahrens zum Betreiben der Einrichtung der Figur 1 und Figur 3 zeigt eine schematische Prinzipdarstellung eines zweiten Ausführungsbeispiels einer erfindungsgemäßen Einrichtung zum Betreiben eines Leistungshalbleiterbauelements.

In leistungselektronischen Einrichtungen, beispielsweise in elektrischen Stromrichtern zur Umformung von Gleich- in Wechselstrom oder umgekehrt, sind häufig Leistungshalbleiterbauelemente enthalten, insbesondere Transistoren wie z.B. IGBTs (IGBT = insulated gate bipolar transistor), oder Thyristoren wie z.B. GTOs (GTO = gate turn off). Aufgrund der zu schaltenden Ströme erwärmen sich diese Leistungshalbleiterbauelemente in Abhängigkeit von der jeweiligen Strombelastung. Dieser Erwärmung wird häufig dadurch entgegengewirkt, dass ein Kühlsystem für die Leistungshalbleiterbauelemente vorgesehen ist, mit dem die durch die Strombelastung entstehende Wärme von den Leistungshalbleiterbauelementen abgeführt wird.

In der Figur 1 ist eine Einrichtung 10 zum Betreiben eines Leistungshalbleiterbauelements dargestellt.

In der Figur 1 ist beispielhaft nur ein einziger IGBT 11 gezeigt, der jedoch mehrere oder sämtliche Leistungshalbleiterbauelemente der gesamten leistungselektronischen Einrichtung repräsentieren soll. Es versteht sich, dass anstelle des IGBTs 11 auch andere Leistungshalbleiterbauelemente vorhanden sein können.

Der IGBT 11 ist auf einer Platte 12 montiert, die ihrerseits mit einem Kühlsystem 13 in Verbindung steht. Alternativ kann der IGBT 11 auch auf oder in einem Gehäuse montiert sein. Die Platte 12 ist unter anderem dazu vorgesehen, dass Wärme, die in dem IGBT 11 entsteht, zu dem Kühlsystem 13 abgeleitet wird. Zu diesem Zweck weist die Platte 12 eine hohe Wärmeleitfähigkeit auf und besteht beispielsweise aus Metall. Gegebenenfalls ist es auch möglich, dass die Platte 12 nicht vorhanden ist, und dass der IGBT 11 direkt mit dem Kühlsystem 13 gekoppelt ist.

Das Kühlsystem 13 weist beispielhaft eine Rohrleitung 15 auf, der die Platte 12 zugeordnet ist. Die Rohrleitung 15 führt von einem Behälter 16 über eine Pumpe 17 wieder zurück in den Behälter 16. In dem Behälter 16 ist ein Kühlmedium 18 enthalten. Die Platte 12 und die Rohrleitung 15 sind derart ausgebildet, dass das durch die Rohrleitung 15 strömende Kühlmedium 18 an der Platte 12 vorbeiströmt und dadurch Wärme von dieser Platte 12 abführen kann.

Bei dem Kühlmedium 18 kann es sich um eine Flüssigkeit, z.B. um Wasser handeln. In diesem Fall ist die Pumpe 17 als hydraulische Pumpe ausgebildet und der Behälter 16 kann offen sein. Bei dem Kühlmedium 18 kann es sich aber auch um ein Gas, z.B. um Luft handeln. In diesem Fall ist die Pumpe 17 als pneumatische Pumpe ausgebildet und der Behälter 16 ist vorzugsweise geschlossen. Zusätzlich kann in diesem Fall die Rohrleitung 15 und der Behälter 16 gasdicht verschlossen sein und das Kühlsystem 13 kann gegebenenfalls unter Druck stehen.

Das Kühlmedium 18 wird von der Pumpe 17 in Richtung der in der Figur 1 angegebenen Pfeile durch die Rohrleitung 15 gepumpt. Bei der Pumpe 17 handelt es sich um eine steuerbare Pumpe, deren Drehzahl und damit deren Fördermenge in Abhängigkeit von einem Eingangssignal E variabel einstellbar ist. Damit ist die durch die Rohrleitung 15 geförderte Menge an Kühlmedium 18 variabel und hängt von dem Eingangssignal E ab.

Im Betrieb der Einrichtung 10 werden von dem IGBT 11 laufend Ströme umgeschaltet. Dadurch wird der IGBT 11 erwärmt. Zur Kühlung des IGBT 11 wird das Kühlmedium 18 von der Pumpe 17 durch die Rohrleitung 15 gefördert. Die von dem IGBT 11 erzeugte Wärme wird über die Platte 12 an das Kühlmedium 18 abgegeben und zusammen mit dem Kühlmedium 18 abtransportiert.

In der Figur 2 ist ein Verfahren dargestellt, mit dem die Einrichtung 10 der Figur 1 betrieben werden kann.

Ein Block 21 repräsentiert eine Steuerung und/oder Regelung, von der der IGBT 11 beeinflusst wird, und mit deren Hilfe die erläuterten laufenden Umschaltungen der Ströme durch den IGBT 11 ausgelöst werden. Es versteht sich, dass diese Steuerung und/oder Regelung nicht auf die Beeinflussung des beispielhaft erläuterten einzigen IGBT 11 beschränkt ist, sondern mehrere oder auch sämtliche vorhandenen Leistungshalbleiterbauelemente ansteuern kann. Ebenfalls versteht es sich, dass im Rahmen dieser Steuerung und/oder Regelung eine Vielzahl von Betriebsgrößen der Einrichtung 10 verarbeitet werden und damit vorhanden sind. Dabei handelt es sich beispielsweise um aktuell über den oder die Leistungshalbleiterbauelemente fließende Ströme und/oder um mögliche Stromänderungen aufgrund von Veränderungen der Steuer- und/oder Regelparameter.

Derartige Betriebsgrößen werden von der Steuerung und/oder Regelung an einen Block 22 weitergegeben, der eine Vorausschau repräsentiert. Bei dieser Vorausschau wird ermittelt, welcher Stromverlauf voraussichtlich in naher Zukunft über den oder die Leistungshalbleiterbauelemente vorhanden sein wird. Dieser zukünftige Stromverlauf wird insbesondere aus den aktuellen Strömen und den vorgesehenen Veränderungen der Steuer- und/oder Regelparameter abgeleitet.

Die vorgenannte Vorausschau bezieht sich dabei insbesondere auf einen zukünftigen Zeitbereich von beispielsweise ein bis drei Minuten. Dieser Zeitbereich hängt unter anderem ab von den verwendeten Leistungshalbleiterbauelementen und deren Zeitkonstanten im Hinblick auf Wärmeveränderungen sowie von dem verwendeten Kühlsystem 13 und dessen Zeitkonstante im Hinblick auf Wärmeveränderungen sowie von der Schnelligkeit der vorhandenen Steuerung und/oder Regelung des Blocks 21.

Im Hinblick auf die Figur 1 bedeutet dies, dass in dem Block 22 der Figur 2 der voraussichtliche zukünftige Stromverlauf des über den IGBT 11 fließenden Stroms ermittelt wird. Dieser Stromverlauf wird an einen Block 23 weitergegeben.

Der Block 23 der Figur 2 repräsentiert ein Modell des Kühlsystems 13 der Figur 1. In diesem Modell ist das gesamte Kühlsystem 13 rechnerisch nachgebildet. Weiterhin kann diesem Modell die aktuelle Temperatur des IGBT 11 oder der Platte 12 als Eingangssignal zugeführt sein. Diese Temperatur kann von einem dem IGBT 11 oder der Platte 12 zugeordneten Sensor 24 direkt gemessen oder auf sonstige Weise indirekt ermittelt werden. Es versteht sich, dass dem Modell auch noch weitere Betriebsgrößen der Einrichtung 10 zugeführt sein können, beispielsweise weitere gemessene oder berechnete Temperaturen des Kühlsystems 13 oder dergleichen.

Mit Hilfe des Modells kann unter anderem ermittelt werden, wie viel Wärme von dem IGBT 11 bei einem bestimmten aktuellen Strom erzeugt wird. Entsprechend kann von dem Modell ermittelt werden, wie viel Wärme von dem IGBT 11 bei einem voraussichtlichen zukünftigen Stromverlauf erzeugt wird. Weiterhin kann mit Hilfe des Modells ermittelt werden, wie viel Wärme von dem IGBT 11 über die Platte 12 und über die Rohrleitung 15 aktuell und zukünftig an das Kühlmedium 18 abgegeben wird. In Abhängigkeit von der Temperatur des Kühlmediums 18 und in Abhängigkeit von möglichen Drehzahlen der Pumpe 17 kann dann von dem Modell auch ermittelt werden, wie viel Wärme von dem Kühlmedium 18 aktuell und zukünftig zu dem Behälter 16 abgeführt werden kann.

Mit Hilfe des Modells des Blocks 23 der Figur 2 kann also vorausberechnet werden, wie sich das Kühlsystem 13 der Figur 1 ausgehend vom aktuellen Strom über den IGBT 11 für einen voraussichtlichen zukünftigen Stromverlauf bei unterschiedlichen Drehzahlen der Pumpe 17 verhalten wird. Diese Vorausberechnung wird von dem Block 23 an einen Block 25 weitergegeben.

Der Block 25 repräsentiert eine gesteuerte und/oder geregelte Konstanthaltung der Temperatur des IGBT 11. Bei dieser Konstanthaltung wird ermittelt, mit welcher Drehzahl die Pumpe 17 betrieben werden muss, damit die Temperatur des IGBT 11 möglichst konstant bleibt.

In dem Block 25 wird ausgehend von der über das Kühlmedium 18 abgeführten Wärme wieder "zurück" gerechnet, welche Temperatur sich aufgrund der abgeführten Wärme bei einer bestimmten Drehzahl der Pumpe 17 im Bereich der Platte 12 und damit an dem IGBT 11 ergeben würde. Diese Berechnung wird dann für die unterschiedlichen Drehzahlen mit dem Ziel durchgeführt, diejenige optimale Drehzahl der Pumpe 17 zu ermitteln, bei der sich die Temperatur der Platte 12 bzw. des IGBT 11 möglichst nicht ändert. Die ermittelte optimale Drehzahl wird dann als Eingangssignal E an die Pumpe 17 weitergegeben.

Mit Hilfe der Konstanthaltung des Blocks 25 wird also die Drehzahl der Pumpe 17 und damit die Fördermenge an Kühlmedium 18 gerade so eingestellt, dass zukünftige Veränderungen der Temperatur des IGBT 11, die sich aufgrund des zukünftigen Stromverlaufs über den IGBT 11 voraussichtlich ergeben würden, gerade kompensiert werden. Die Drehzahl der Pumpe 17 wird also immer gerade so eingestellt, dass die sich daraus ergebende, über das Kühlmedium 18 abgeführte Wärme den voraussichtlichen zukünftigen Erwärmungen bzw. Abkühlungen des IGBT 11 entgegenwirkt und die Temperatur des IGBT 11 damit möglichst konstant bleibt.

Würde sich also der IGBT 11 an sich aufgrund des zukünftigen Stromverlaufs voraussichtlich erwärmen, so wird die Drehzahl der Pumpe 17 gerade so erhöht, dass die von dem IGBT 11 erzeugte Wärme über das Kühlmedium 18 abgeführt und die Temperatur des IGBT 11 damit im wesentlichen konstant bleibt. Entsprechend wird die Drehzahl der Pumpe 17 und damit die Abführung von Wärme über das Kühlmedium 18 gerade so vermindert, dass eine geringere Wärme, die von dem IGBT 11 aufgrund des voraussichtlichen Stromverlaufs erzeugt wird, zu keiner Abkühlung des IGBT 11 führt.

Es versteht sich, dass das erläuterte Verfahren der Figur 2 nicht nur auf den beispielhaft erläuterten einzigen IGBT 11 der Figur 1 beschränkt ist, sondern in entsprechender Weise auch auf mehrere oder sämtliche Leistungshalbleiterbauelemente der Einrichtung 10 der Figur 1 angewendet werden kann. Ebenfalls versteht es sich, dass dieses Verfahren auf unterschiedliche Weisen realisiert sein kann, beispielsweise als Computerprogramm, das auf einem digitalen Computer abläuft, wobei dann der Computer zur Ansteuerung der Pumpe 17 vorgesehen ist, oder auch als analoge Schaltung, die dann die Pumpe 17 ansteuert.

In der Figur 3 ist eine Einrichtung 20 zum Betreiben eines Leistungshalbleiterbauelements dargestellt.

In der Figur 3 ist beispielhaft nur ein einziger IGBT 21, der jedoch - wie in der Figur 1 - eine Mehrzahl von Leistungshalbleiterbauelementen repräsentieren soll. Der IGBT 21 ist auf einer Platte 22 montiert, die ihrerseits einem Kühlsystem zugeordnet ist. Das Kühlsystem weist einen Primärkreislauf 23 und einen Sekundärkreislauf 24 auf, die über einen Wärmetauscher 25 miteinander gekoppelt sind.

Der Primärkreislauf 23 ist aus einer geschlossenen Rohrleitung 28 aufgebaut, in die eine Pumpe 29 zwischengeschaltet ist. Mit Hilfe der Pumpe 29 wird ein flüssiges oder gasförmiges Kühlmedium in Richtung der in der Figur 3 angegebenen Pfeile durch die Rohrleitung 28 gepumpt. Die Drehzahl der Pumpe 29 ist dabei konstant. Die Platte 22 und die Rohrleitung 28 sind derart ausgebildet, dass das Kühlmedium von dem IGBT 21 erzeugte Wärme abtransportieren kann.

Der Sekundärkreislauf 24 weist eine Rohrleitung 31 auf, in der eine Pumpe 32 und ein Ventil 33 enthalten ist. Die Rohrleitung 31 ist offen, so dass ein flüssiges oder gasförmiges Kühlmedium 34 von der Pumpe 32 aus einem Behälter 35 gefördert und in Richtung der in der Figur 3 angegebenen Pfeile durch die Rohrleitung 31 wieder zurück in den Behälter 35 gepumpt werden kann. Die Drehzahl der Pumpe 32 ist dabei vorzugsweise konstant.

Bei dem Ventil 33 handelt es sich um ein steuerbares Ventil, dessen Durchlassquerschnitt und damit dessen Durchlassmenge in Abhängigkeit von einem Eingangssignal E variabel einstellbar ist. Das Ventil 33 kann elektrisch, hydraulisch oder pneumatisch ausgebildet sein. Mit dem Ventil 33 ist die durch die Rohrleitung 31 geförderte Menge an Kühlmedium 34 variabel und hängt von dem Eingangssignal E ab.

Im Betrieb der Einrichtung 20 werden von dem IGBT 21 laufend Ströme umgeschaltet. Dadurch wird der IGBT 21 erwärmt. Zur Kühlung des IGBT 21 wird das Kühlmedium des Primärkreislaufs 23 von der Pumpe 29 laufend durch die Rohrleitung 28 gefördert. Von dem Primärkreislauf 23 wird dann Wärme über den Wärmetauscher 25 an den Sekundärkreislauf 24 abgegeben. Dort wird die Wärme von der Pumpe 32 laufend mit Hilfe des Kühlmediums 34 abgeführt.

Das anhand der Figur 2 erläuterte Verfahren kann in entsprechender Weise auch bei der Einrichtung 20 der Figur 3 zur Anwendung kommen. In diesem Fall muss bei dem Verfahren der Figur 2 berücksichtigt werden, dass anstelle der Pumpe 17 der Figur 1 nunmehr das steuerbare Ventil 33 der Figur 3 vorhanden ist, und dass deshalb das Eingangssignal E nicht die Drehzahl der Pumpe 17 wie bei der Figur 1 darstellt, sondern den Durchlassquerschnitt des Ventils 33 der Figur 3. Weiterhin muss bei dem Modell des Blocks 23 berücksichtigt werden, dass anstelle des Kühlsystems 13 der Figur 1 nunmehr der Primärkreislauf 23 und der Sekundärkreislauf 24 der Figur 3 sowie deren Kopplung über den Wärmetauscher 25 vorhanden sind.

Von dem Verfahren der Figur 2 wird dann das Ventil 33 der Figur 3 mittels des Eingangssignals E derart angesteuert, dass die durch den Sekundärkreislauf 24 geförderte Menge an Kühlmedium 34 gerade so groß ist, dass dem Kühlmedium des Primärkreislaufs 23 über den Wärmetauscher 25 so viel Wärme entzogen wird, dass die Temperatur des IGBT 21 auch bei Änderungen des Stromverlaufs über den IGBT 21 im wesentlich konstant bleibt.

Würde sich also der IGBT 21 an sich aufgrund des zukünftigen Stromverlaufs voraussichtlich erwärmen, so wird der Öffnungsquerschnitt des Ventils 33 gerade so vergrößert, dass die von dem IGBT 21 erzeugte Wärme über das Kühlmedium des Primärkreislaufs 23, den Wärmetauscher und das Kühlmedium 34 des Sekundärkreislaufs 24 abgeführt und die Temperatur des IGBT 21 damit im wesentlichen konstant bleibt. Entsprechend wird der Öffnungsquerschnitt des Ventils 33 und damit die Abführung von Wärme über das Kühlmedium des Primärkreislaufs 23 und das Kühlmedium 34 des Sekundärkreislaufs 24 gerade so vermindert, dass eine geringere Wärme, die von dem IGBT 21 aufgrund des voraussichtlichen Stromverlaufs erzeugt wird, zu keiner Abkühlung des IGBT 21 führt.

Alternativ oder additiv ist es möglich, dass die Pumpe 32 der Figur 3 keine konstante Drehzahl aufweist, sondern variabel steuerbar ist. In diesem Fall kann die Pumpe 32 mit dem Eingangssignal E der Figur 2 angesteuert werden. Die Menge an gefördertem Kühlmedium 34 im Sekundärkreislauf 24 ist dann von der Pumpe 32 und/oder dem Ventil 33 abhängig.

Bei der Einrichtung 10 der Figur 1 ist es möglich, dass die Pumpe 17 nicht variabel einstellbar ist, sondern eine konstante Drehzahl aufweist. In diesem Fall können in nicht-dargestellter Weise zwei Speicher vorhanden sein, die mit jeweils einem Kühlmedium gefüllt sind, deren Temperatur einerseits kleiner und andererseits größer als die Temperatur des Kühlmediums 18 ist. Beispielsweise kann es sich dabei um einen Warmwasserspeicher und einen Kaltwasserspeicher handeln. In Abhängigkeit von dem Eingangssignal E kann dann der Rohrleitung 15 entweder Kühlmedium aus dem Kaltwasserspeicher oder aus dem Warmwasserspeicher zugeführt werden. Dieses zusätzlich zugeführte Kühlmedium hat dann in gleicher Weise wie die Veränderung der Drehzahl der Pumpe 17 zur Folge, dass die Temperatur des IGBT 11 etwa konstant bleibt, obwohl sie sich aufgrund eines veränderten zukünftigen Stromverlaufs an sich verändern würde.

Bei der Einrichtung 20 der Figur 20 ist es in entsprechender Weise möglich, das Ventil 33 entfallen zu lassen und statt dessen zusätzliches Kühlmedium aus einem Warmwasserspeicher und einem Kaltwasserspeicher dem Sekundärkreislauf 24 zuzuführen. Auch in diesem Fall kann in Abhängigkeit von dem Eingangssignal E gerade so viel zusätzliches Kühlmedium zugeführt werden, dass eine an sich erfolgende zukünftige Veränderung der Temperatur des IGBT 21 gerade kompensiert wird und die Temperatur des IGBT 21 etwa konstant bleibt.

## Patentansprüche

1. Verfahren zum Betreiben eines Leistungshalbleiterbauelements, insbesondere eines IGBT (IGBT = insulated gate bipolar transistor), wobei dem Leistungshalbleiterbauelement ein Kühlsystem zugeordnet ist, das ein Kühlmedium enthält, mit dem von dem Leistungshalbleiterbauelement erzeugte Wärme von demselben abgeführt wird, und wobei die durch das Kühlsystem geförderte Menge an Kühlmedium eingestellt wird, **dadurch gekennzeichnet, dass** die durch das Kühlsystem geförderte Menge an Kühlmedium derart gesteuert und/oder geregelt wird, dass gerade so viel Wärme von dem Leistungshalbleiterbauelement abgeführt wird, dass die Temperatur des Leistungshalbleiterbauelements im wesentlichen konstant bleibt (25).

2. Verfahren nach Anspruch 1, wobei die durch das Kühlsystem geförderte Menge an Kühlmedium derart gesteuert und/oder geregelt wird, dass eine voraussichtliche zukünftige Temperaturänderung des Leistungshalbleiterbauelements kompensiert wird.

3. Verfahren nach einem der Ansprüche 1 oder 2, wobei die durch das Kühlsystem geförderte Menge an Kühlmedium erhöht wird, wenn sich die Temperatur des Leistungshalbleiterbauelements zukünftig voraussichtlich erhöht, und wobei die durch das Kühlsystem geförderte Menge an Kühlmedium vermindert wird, wenn sich die Temperatur des Leistungshalbleiterbauelements zukünftig voraussichtlich vermindert.

4. Verfahren nach einem der Ansprüche 2 oder 3, wobei eine voraussichtliche zukünftige Temperaturänderung oder eine zukünftige voraussichtliche Temperatur des Leistungshalbleiterbauelements in Abhängigkeit von einem voraussichtlichen zukünftigen Stromverlauf über das Leitungshalbleiterbauelement ermittelt wird (22).

5. Verfahren nach einem der vorstehenden Ansprüche, wobei das Kühlsystem in der Form eines Modells rechnerisch nachgebildet wird (23).

6. Verfahren nach Anspruch 5, wobei eine voraussichtliche zukünftige Temperaturänderung oder eine zukünftige voraussichtliche Temperatur des Leistungshalbleiterbauelements mit Hilfe des Modells ermittelt wird.

7. Verfahren nach einem der Ansprüche 5 oder 6, wobei weitere Betriebsgrößen des Kühlsystems und/oder des Leistungshalbleiterbauelements von dem Modell verarbeitet werden.

8. Einrichtung (10, 20) zum Betreiben eines Leistungshalbleiterbauelements, insbesondere eines IGBT (IGBT = insulated gate bipolar transistor), wobei dem Leistungshalbleiterbauelement ein Kühlsystem zugeordnet ist, das ein Kühlmedium enthält, mit dem von dem Leistungshalbleiterbauelement erzeugte Wärme von demselben abführbar ist, und wobei die durch das Kühlsystem geförderte Menge an Kühlmedium einstellbar ist, **dadurch gekennzeichnet, dass** Mittel vorgesehen sind, die dazu ausgebildet sind, die durch das Kühlsystem geförderte Menge an Kühlmedium derart zu steuern und/oder zu regeln, dass gerade so viel Wärme von dem Leistungshalbleiterbauelement abgeführt wird, dass die Temperatur des Leistungshalbleiterbauelements im wesentlichen konstant bleibt.

9. Einrichtung (10, 20) nach Anspruch 8, wobei die Mittel ein Modell zur rechnerischen Nachbildung des Kühlsystems und/oder des Leistungshalbleiterbauelements aufweisen.

10. Einrichtung (10) nach einem der Ansprüche 8 oder 9, wobei das Kühlsystem eine einstellbare Pumpe (17) zur Steuerung der durch das Kühlsystem geförderten Menge an Kühlmedium aufweist.

11. Einrichtung (20) nach einem der Ansprüche 8 oder 9, wobei das Kühlsystem ein einstellbares Ventil (33) zur Steuerung der durch das Kühlsystem geförderten Menge an Kühlmedium aufweist.
